# EUROPEAN PATENT APPLICATION

(11) **EP 2 418 752 A1**
(43) Date of publication of application: **15.02.2012**
(21) Application number: 10772120.1
(22) Date of filing: 06.05.2010
(51) Int. Cl.: H02J 7/02, H01M 10/44, H02J 7/00

(54) **POWER SUPPLY DEVICE AND BATTERY PACK**

(30) Priority: 08.05.2009 JP 2009113285
(71) Applicant: Panasonic Corporation, Kadoma-shi Osaka 571-8501 (JP)
(72) Inventor: IIDA, Takuma, Chuo-ku, Osaka-shi, Osaka 540-6207 (JP); KIRUMA, Tadao, Chuo-ku, Osaka-shi, Osaka 540-6207 (JP)
(74) Representative: Schwabe - Sandmair - Marx
(86) International application number: PCT/JP2010/003115
(87) International publication number: WO 2010/128596

(57) **Abstract**

A temperature detection portion 41 captures temperature detection values detected by a plurality of temperature sensors T disposed at prescribed positions of a battery portion 2 with a prescribed period, to detect the state of the battery portion 2. An abnormality judgment portion 42 compares the temperature detection values detected by the temperature detection portion 41 with a threshold value determined in advance, to judge whether the state of the battery portion 2 is abnormal. In a case where the abnormality judgment portion 42 judges that the battery portion 2 is abnormal, a charge/discharge control portion 43 causes a switching element 5 to operate in an on/off sequence set in advance, and then turns off the switching element 5.

## Description

### Technical Field

This invention relates to a power supply device used for portable equipment, for backup, and in various other devices and systems.

### Background Art

With rapid advances toward an information-centric society, secondary batteries have become increasingly important as power supplies for portable equipment and as backup power supplies for information systems. Particularly in recent years, more compact and lightweight power supplies have been demanded, in light of the need for long-term use and decreased space requirements, and secondary batteries have also shifted from conventional lead storage batteries to nickel hydride batteries, lithium ion secondary batteries, and other high-performance batteries, which are widely in use.

Since these high-performance batteries all have high energy densities, appropriate charge/discharge management is necessary to enable safe long-term use. For this reason, rather than use as single secondary batteries, it is normal to use secondary battery packs which combine secondary batteries with a battery monitoring device for monitoring secondary batteries and controlling charging and discharging. In order to control charging of such a secondary battery pack, communication of charging control signals between the secondary battery pack and the charger has become common (see for example Patent Document 1).

However, the output voltage of a secondary battery pack is determined by the type and number of the incorporated secondary batteries, and so when a higher output voltage is required, a secondary battery pack must be newly designed and developed with an increased number of secondary batteries. Hence rather than designing and manufacturing secondary battery packs separately according to the output voltage required, it is more economical to connect a plurality of secondary battery packs in series to obtain the desired output voltage (see for example Patent Document 2).

However, in Patent Document 1, connection terminals and a communication circuit are required in order to perform communication of charging control signals between the secondary battery pack and the charger, and so there is the problem that costs are increased.

Further, in a case where communication is performed between a charger and a plurality of secondary battery packs connected in series, as in the invention described in Patent Document 2, special measures are necessary for communication between the secondary battery packs and the charger. That is, normally the secondary battery packs connected in series generate communication signals using the output voltage of secondary batteries of the respective secondary battery packs as the power supply voltage for operation.

In such a case, seen from the side of the charger, the secondary battery packs are series-connected, so that potential differences occur between the communication signals output from each of the secondary battery packs, and on the charger side, wraparound of communication signals between the secondary battery packs occurs.

Hence there is the problem that in order to effect communication of the charger with a plurality of series-connected secondary battery packs, communication lines must be insulation-treated, the power supply voltage for operation of the secondary battery packs must be supplied from outside, and similar. Further, communication control, such as control of the order of priority of communication between the plurality of secondary battery packs and the charger, becomes complicated, and so there is the problem that the overall control system becomes extremely complicated.

This invention has as an object the provision of a battery pack and a power supply device comprising the battery pack which can notify another battery pack or similar of an abnormality in its own battery portion, without separately providing a communication circuit and similar.

Patent Document 1: Japanese Patent Application Laid-open No. H4-95364
Patent Document 2: Japanese Patent Application Laid-open No. 2007-280757

### Summary of the Invention

The power supply device of one aspect of the invention is a power supply device comprising a plurality of series-connected battery packs, **characterized in that** each battery pack includes a battery portion including one or a plurality of secondary batteries; a connection terminal which receives current flowing in the battery portion; a switching element which opens and closes a charge/discharge path between the battery portion and the connection terminal; a state detection portion which detects a state of the battery portion; an abnormality judgment portion which judges whether the state of the battery portion is abnormal, based on the state of the battery portion detected by the state detection portion; a charge/discharge control portion which, when the state of the battery portion has been judged to be abnormal by the abnormality judgment portion, after operating the switching element using an on/off sequence set in advance, turns off the switching element; and a first current detection portion which detects a current flowing in the battery portion; and in that, when the current detected by the first current detection portion has changed in a current change pattern corresponding to the on/off sequence, the abnormality detection portion judges that another battery pack is abnormal, and turns off the switching element.

### Brief Description of the Drawings

[Fig. 1] Fig. 1 is a block diagram showing an example of the configuration of the power supply device of one embodiment of the invention;
[Fig. 2] Fig. 2 is a waveform diagram showing an example of a current change pattern;
[Fig. 3] Fig. 3 is a flowchart showing an example of operation of a battery pack constituting the power supply device shown in Fig. 1; and
[Fig. 4] Fig. 4 is a flowchart showing an example of operation when the control portion of a power supply device detects a battery pack abnormality.

### Best Mode For Carrying Out the Invention

Below, an embodiment of the invention is explained based on the drawings. In each figure, elements to which the same symbol is assigned are the same, and explanations thereof are omitted. Further, the following embodiment is one specific example of the invention, and does not limit the technical scope of the invention.

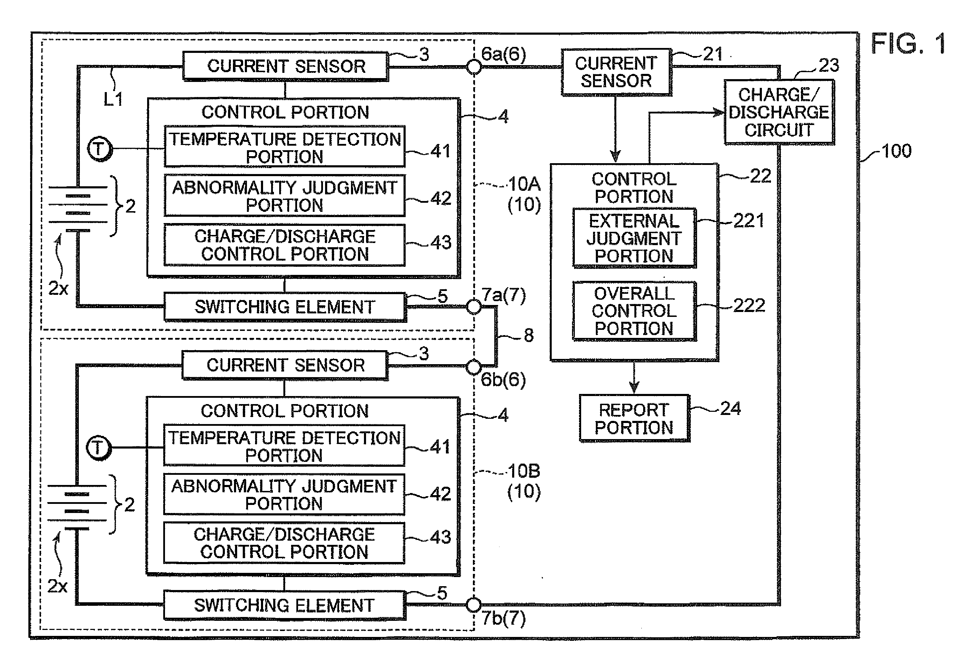

Fig. 1 is a block diagram showing an example of the configuration of the power supply device 100 of one embodiment of the invention. The power supply device 100 shown in Fig. 1 mainly comprises two battery packs 10A, 10B connected in series, a current sensor 21 (an example of a second current detection portion), a control portion 22, a charge/discharge current 23, and a report portion 24. The bold line in Fig. 1 indicates the charge/discharge path L1.

The battery pack 10A and the battery pack 10B are configured identically. Below, when no distinction in particular is made between the battery pack l0A and the battery pack 10B, both are referred to as battery pack 10.

The battery pack 10 comprises the battery portion 2, current sensor 3 (an example of a first current detection portion), control portion 4, and switching element 5.

The battery portion 2 comprises a battery module provided with a plurality of (for example, four) secondary batteries 2x, connected in series. As the secondary batteries 2x, for example lithium ion secondary batteries, nickel hydride secondary batteries, or various other secondary batteries can be adopted.

The battery portion 2 is not limited to a plurality of secondary batteries 2x connected in series, but may be configured as a plurality of secondary batteries 2x connected in parallel; or, a configuration may be adopted in which a plurality of parallel-connected secondary batteries 2x and a plurality of series-connected secondary batteries 2x are intermixed. Further, a single secondary battery 2x may be adopted as the battery portion 2.

The battery pack 10A comprises connection terminals 6a and 7a. The battery pack 10B comprises connection terminals 6b and 7b. Below, the connection terminals 6a and 6b are collectively referred to as connection terminals 6, and the connection terminals 7a and 7b are collectively referred to as connection terminals 7.

The current sensors 3 are provided in the charge/discharge path L1 between the positive electrodes of the battery portions 2 and the connection terminals 6, and detect current flowing in the battery portion 2. The current sensors 3 detect current in for example the charging direction as a positive current value, and current in the discharging direction as a negative current value.

Specifically, the current sensors 3 comprise for example a shunt resistance and current transformer, an analog/digital converter which converts the current value converted into an analog voltage by the shunt resistance and current transformer into a digital value and outputs this to the control portion 4, and similar. The analog/digital converter may also be incorporated within the control portion 4.

Here, the charging direction refers to the counterclockwise direction of the charge/discharge path L1, and the discharging direction refers to the clockwise direction of the charge/discharge path L1.

The switching elements 5 are provided in the charge/discharge path L1 between the negative electrodes of the battery portions 2 and the connection terminals 7, and pass current between the battery portions 2 and the connection terminals 7 upon being turned on, but shut off current between the battery portions 2 and the connection terminals 7 when turned off, and so open and close the charge/discharge path L1.

Here, as the switching elements 5, for example FETs (Field Effect Transistors), bipolar transistors, or other semiconductor switching elements can be adopted.

The connection terminals 6 and 7 may for example comprise electrodes, connectors, terminal blocks or similar, and may comprise lands, pads, or other wiring patterns.

The connection terminals 6 are connected to the connection terminals 7 via the current sensors 3, battery portions 2, and switching elements 5. Further, the connection terminals 6 are positive terminals used for connection to the positive-electrodes sides of the battery portions 2, and the connection terminals 7 are negative terminals used for connection to the negative-electrode sides of the battery portions 2.

The control portions 4 are each configured comprising for example a CPU (Central Processing Unit) which executes prescribed computation processing, non-volatile ROM (Read Only Memory) which stores a prescribed control program, RAM (Random Access Memory) which temporarily stores data, peripheral circuitry, and similar.

The control portions 4, by for example executing a control program stored in ROM, each function as a temperature detection portion 41 (one example of a state detection portion), abnormality judgment portion 42, and charge/discharge control portion 43.

A temperature detection portion 41 detects a state of a battery portion 2 by capturing a temperature detection value, detected by a plurality of temperature sensors T disposed in prescribed positions of the battery portion 2, from the temperature sensors T with a prescribed period. The temperature detection portion 41 outputs a plurality of temperature detection values captured with a prescribed period to the abnormality judgment portion 42 with a prescribed period.

An abnormality judgment portion 42, by comparing a temperature detection value detected by the temperature detection portion 41 with a threshold value determined in advance, judges whether the state of the battery portion 2 is abnormal. Here, abnormal states of the battery portion 2 include states in which degradation of the battery portion 2 is advancing to a certain degree, and states in which the battery portion 2 has malfunctioned.

Specifically, the abnormality judgment portion 42 determines the average value of a plurality of temperature detection values output with the same timing from the temperature detection portion 41, and when this average value is greater than a threshold value TH1, judges the battery portion 2 to be abnormal.

Further, the abnormality judgment portion 42 may use weighting coefficients, determined in advance according to the disposition sites of the temperature sensors T, to compute a weighted average value of the plurality of temperature detection values output with the same timing from the temperature detection portion 41, and when this weighted average value is greater than a threshold value TH1, may judge the battery portion 2 to be abnormal.

Further, the abnormality judgment portion 42 may judge whether each of the plurality of temperature detection values output with the same timing from the temperature detection portion 41 are greater than the threshold value TH1 determined in advance, and when the number of temperature detection values judged to be greater than the threshold value TH1 is a prescribed number (for example one, or two, or all values), may judge that the battery portion 2 is abnormal.

Further, the abnormality judgment portion 42 may, in addition to or in place of the above judgment processing, determine the variation in the plurality of temperature detection values output with the same timing from the temperature detection portion 41, and when the variation is greater than a threshold value TH2 determined in advance, may judge the battery portion 2 to be abnormal. Here, as the variation in a plurality of temperature detection values, for example the standard deviation, the dispersion, or similar of the plurality of temperature detection values can be adopted.

As threshold values TH1 and TH2, values obtained from actual experiments or similar may be adopted.

And, the abnormality judgment portion 42 notifies the charge/discharge control portion 43 of judgment results as appropriate upon each judgment of whether the battery portion 2 is abnormal.

When the abnormality judgment portion 42 judges that the battery portion 2 is abnormal, the charge/discharge control portion 43 causes the switching element 5 to operate an on/off sequence set in advance, and then turns the switching element 5 off. By this means, the charge/discharge control portion 43 can notify the other battery pack 10 of an abnormality in the battery portion 2. Further, by this means the charge/discharge control portion 43 can forbid charging/discharging of the battery portion 2, and can prevent continued use of the battery portion 2 in the abnormal state and occurrence of a dangerous state.

As the on/off sequence set in advance, it is preferable that a sequence be adopted wherein operation of first turning the switching element 5 off for a constant interval and then turning it on for a constant interval is repeated; it is still more preferable that the first off interval and the first on interval of the switching element 5 be the same; and it is most preferable that the second on interval be longer than the second off interval.

By this means, the duty ratio in the first period of the current change pattern is 50%, and the duty ratio in the second period of the current change pattern is higher than 50%.

By this means the current change pattern waveform can be made unique, mixing of this current change pattern with noise and other signals can be avoided, and an abnormality of the battery pack can be detected with good precision using a small number of pulses.

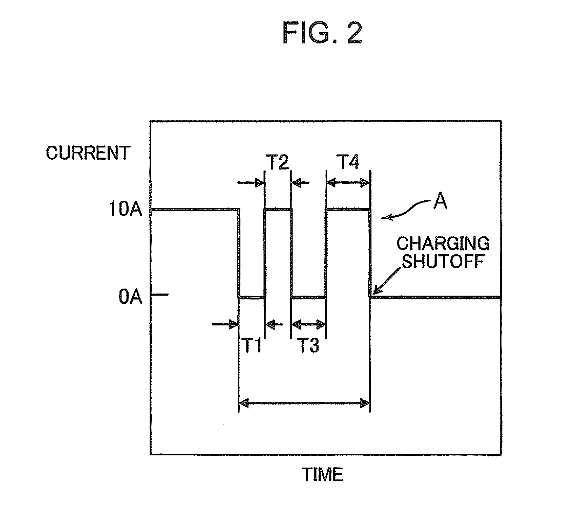

Fig. 2 shows the waveform of the current flowing in the charge/discharge path L1 when the switching element 5 is operated using an on/off sequence set in advance, that is, the waveform showing one example of a current change pattern A corresponding to an on/off sequence.

The vertical axis in Fig. 2 represents current, and the horizontal axis represents time. The current change pattern A shown in Fig. 2 shows a case in which the current flowing in the charge/discharge path L1 is 10 A. When the abnormality judgment portion 42 detects an abnormality in the battery portion 2, the charge/discharge control portion 43 first turns off the switching element 5 for an interval T1, shutting off current. By this means the current value of the current change pattern A becomes 0 A for the interval T1. Here, as the interval T1, for example 3 seconds can be used.

Next, the charge/discharge control portion 43 turns on the switching element 5 for an interval T2, causing current to flow. By this means the current value of the current change pattern A becomes 10 A for the interval T2. Here, as the interval T2, for example the same interval of 3 seconds as the interval T1 can be used.

Next, the charge/discharge control portion 43 turns off the switching element 5 for an interval T3, and shuts off the current. By this means the current value of the current change pattern A becomes 0 A for the interval T3. Here, as the interval T3, for example an interval of 4 seconds, which is longer than the interval T1, can be used.

Next, the charge/discharge control portion 43 turns on the switching element 5 for an interval T4, causing current to flow. By this means the current value of the current change pattern A becomes 10 A for the interval T4. Here, as the interval T4, for example an interval of 5 seconds, which is longer than the interval T3, can be used.

ext, the charge/discharge control portion 43 turns off the switching element 5, and shuts off the current. By this means the current change pattern A ends, and thereafter the switching element 5 continues to remain turfed off, current to a battery portion 2 which is in an abnormal state can be prevented, and a dangerous state can be avoided.

The current change pattern A shown in Fig. 2 is only one example, and each of the values of T1 to T4 are not limited to the values shown in Fig. 2, but may be other values. Further, the current change pattern A shown in Fig. 2 comprises two square waves, but the current change pattern is not limited to this, and the number of square waves may be three or greater.

Returning to Fig. 1, in a case where the abnormality judgment portion 42 judges that its own battery portion 2 is not abnormal, and the current detected by the current sensor 3 changes with the current change pattern A corresponding to the on/off sequence set in advance, it is judged that the other battery pack 10 is abnormal.

For example, in the battery back 10B, in a case where the abnormality judgment portion 42 judges that its own battery portion 2 is not abnormal, and moreover judges that the current detected by the current sensor 3 shows the current change pattern A, the abnormality judgment portion 42 of the battery pack 10B judges that the battery pack 10A is abnormal.

Here, the current change pattern A is set as shown in Fig. 2. Hence in a case where the current value detected by the current sensor 3 first is approximately 0 A over an interval of approximately T1, then exceeds the current threshold ITH (for example 0.1 A) set in advance over an interval of approximately T2, then is approximately 0 A over an interval of approximately T3, then exceeds the current threshold ITH over an interval of approximately T4, and thereafter is approximately 0 A, the abnormality judgment portion 42 judges that the other battery pack 10 is abnormal.

The two battery packs 10 configured in this way are connected by wiring 8, which is the charge/discharge path L1, between the connection terminal 7a of one of the battery packs 10A and the connection terminal 6b of the other battery pack 10B, to form a series circuit of series-connected battery packs. And, the connection terminal 6a of the one battery pack 10A is connected, via the current sensor 21 and charge/discharge circuit 23, to the connection terminal 7b of the other battery pack 10B.

Hence when the switching element 5 of the battery pack 10A or battery pack 10B is operated using the on/off sequence set in advance, a current change pattern A flows in the charge/discharge path L1, and flows through both of the current sensors 3 and the current sensor 21. By this means, a battery pack 10 can identify an abnormality in the other battery pack 10, and an external judgment portion 221 can identify an abnormality in either battery pack 10.

In Fig. 1, an example is shown for the case in which there are two battery packs 10, but configurations are not limited to this case, and a power supply device 100 may be configured using three or more battery packs 10 connected in series, or a power supply device 100 may be configured using a single battery pack 10.

The current sensor 21 is a sensor configured similarly to for example the current sensors 3, and outputs detected current values to the control portion 22. Here the current sensor 21 is provided in the charge/discharge path L1 between the connection terminal 6a and the charge/discharge circuit 23.

The control portion 22 is configured comprising a CPU (Central Processing Unit) which for example executes prescribed computation processing, non-volatile ROM (Read Only Memory) which stores a prescribed control program, RAM (Random Access Memory) which temporarily stores data, peripheral circuitry, and similar.

And, by executing a control program stored for example in ROM, the control portion 22 functions as the external judgment portion 221 and as an overall control portion 222.

In a case where the current detected by the current sensor 21 changes according to the current change pattern A corresponding to the on/off sequence set in advance, the external judgment portion 221 judges that one among the battery packs 10A and 10B is abnormal. Here, processing by the external judgment portion 221 to judge whether there is an abnormality in a battery pack 10 is the same as the processing in the charge/discharge control portions 43 of the battery packs 10, and so a detailed explanation is omitted.

The overall control portion 222 governs overall control of the power supply device 100, and in this embodiment, in a case where an abnormality in a battery pack 10 is detected by the external judgment portion 221 in particular, halts the charge/discharge circuit 23. Further, in a case where the external judgment portion 221 detects an abnormality in a battery pack 10, the overall control portion 222 uses the report portion 24 to report to the user.

The charge/discharge circuit 23 is a charge/discharge circuit which supplies a charge/discharge current to the battery packs 10 and charges/discharges the battery packs 10. Here, as the charge/discharge current 23, for example a constant-current power supply circuit may be adopted, or a constant-voltage power supply circuit may be adopted. Further, as the charge/discharge current 23, a constant-current/voltage circuit, which for example switches to constant-voltage charging when the current is shut off in the battery packs 10 during constant-current charging, may be adopted, or a control circuit comprising an inverter or similar may be adopted.

Here, if any one of a plurality of battery packs 10 is abnormal, each battery pack 10 turns off its own switching element 5, and so it is not necessary for the overall control portion 222 to halt charge/discharge operation by the charge/discharge circuit 23. However, by halting charge/discharge operation by the charge/discharge circuit 23 when charge/discharge is interrupted, power losses in the charge/discharge circuit 23 can be reduced.

The charge/discharge control portion 43 of a battery pack 10 need not necessarily turn off the switching element 5 after execution of the on/off sequence; a configuration may be adopted in which, by causing the overall control portion 222 to halt the charge/discharge operation of the charge/discharge circuit 23, charge/discharge of the battery portion 2 is ended.

The report portion 24 comprises for example an LED (Light Emitting Diode), and under the control of the overall control portion 222, reports whether an abnormality exists in a battery pack 10 to the user. Here the report portion 24 may report an abnormality of a battery pack 10 by lighting, or may report that battery packs 10 are normal by remaining extinguished.

Further, the report portion 24 may report whether battery packs 10 are abnormal or are normal by lighting with the color changed, as for example using green for normal and red for abnormal. Further, the report portion 24 is not limited to an LED, but may for example employ a liquid crystal display, a buzzer, or similar.

In a case where a liquid crystal display is adopted as the report portion 24, when an abnormality of a battery pack 10 is detected, at least one among text and a symbol may be displayed to indicate that a battery pack 10 is abnormal.

Further, when a buzzer is adopted as the report portion 24, when an abnormality of a battery pack 10 is detected, a prescribed beeping sound may be output, or a voice indicating the presence of an abnormality may be output.

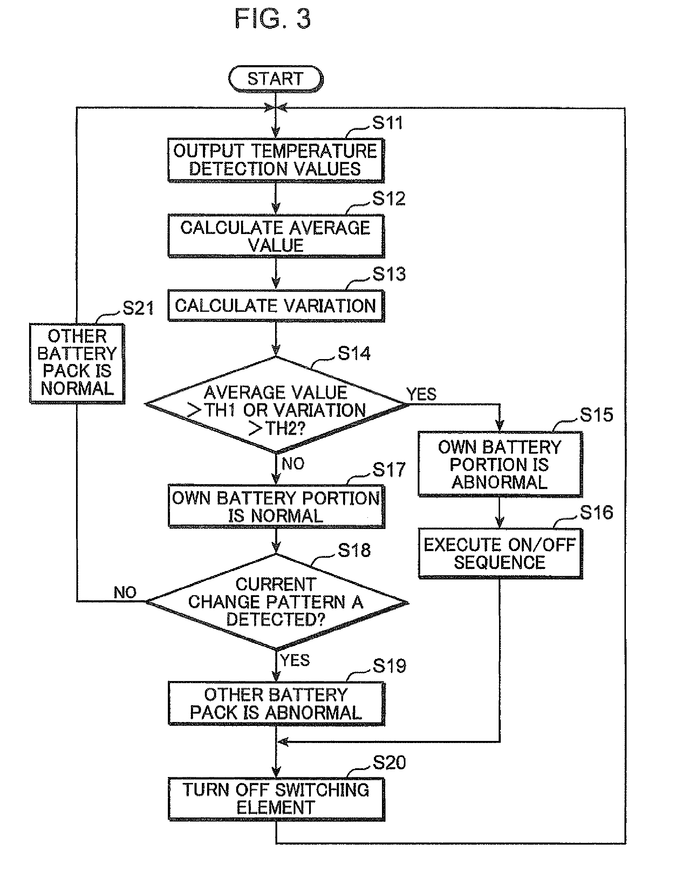

Next, operation of a power supply device 100 configured as described above is explained. Fig. 3 is a flowchart showing an example of operation of a battery pack 10 constituting the power supply device 100 shown in Fig. 1.

Processing at the time of detection of an abnormality in battery packs 10 is explained referring to Fig. 3. First, a temperature detection portion 41 captures temperature detection values detected by each of a plurality of temperature sensors T, and detects the temperature of the battery portion 2 (step S11).

Next, the abnormality judgment portion 42 calculates the average value of a plurality of temperature detection values output from the temperature detection portion 41 with the same timing (step S12).

Next, the abnormality judgment portion 42 calculates the variation of the plurality of temperature detection values output from the temperature detection portion 41 with the same timing (step S13).

Next, the abnormality judgment portion 42 judges whether the average value of temperature detection values calculated in step S12 is greater than a threshold value TH1, and judges whether the variation of temperature detection values calculated in step S13 is greater than a threshold value TH2 (step S14).

And, when the average value of the temperature detection values is greater than the threshold value TH1 or when the variation of the temperature detection values is greater than the threshold value TH2 (YES in step S14), the abnormality judgment portion 42 judges that its own battery portion 2 is abnormal (step S15).

Next, the charge/discharge control portion 43 causes the switching element 5 to operate using the on/off sequence set in advance (step S16), and processing proceeds to step S20.

If on the other hand in step S14 the average value of the temperature detection values is equal to or less than the threshold value TH1 and moreover the variation of the temperature detection values is equal to or less than the threshold value TH2 (NO in step S14), the abnormality judgment portion 42 judges that its own battery portion 2 is normal (step S17).

Next, when the current detected by the current sensor 3 is detected to exhibit the current change pattern A (YES in step S18), the abnormality judgment portion 42 judges that the battery portion 2 of the other battery pack 10 is abnormal (step S19).

Next, the charge/discharge control portion 43 turns off its own switching element 5 (step S20), and processing returns to step S11. Here, when for example in the battery pack 10A the on/off sequence is executed, because the battery packs 10A and 10B are connected in series, the currents detected by the current sensor 3 in the battery pack 10B and by the current sensor 21 1 also change according to the on/off sequence, and exhibit the current change pattern A.

As a consequence, even when a communication circuit to communicate with the battery pack 10B and a communication circuit to communicate with the control portion 22 are not provided in the battery pack 10A, when there is an abnormality in its own battery portion 2, the battery pack 10A can notify the battery pack 10B and the control portion 22.

Further, returning to the processing of step S20, the supply of current from the charge/discharge circuit 23 is cut off to both a battery pack 10 which has detected an abnormality in its own battery portion 2, and also to a battery pack 10 which has detected an abnormality in the battery portion 2 of the other battery pack 10.

On the other hand, when in step S18 the current change pattern A is not detected (NO in step S18), the charge/discharge control portion 43 judges that the battery portion 2 of the other battery pack 10 is normal (step S21), processing returns to step S11, and the processing of steps S11 to S21 is repeated.

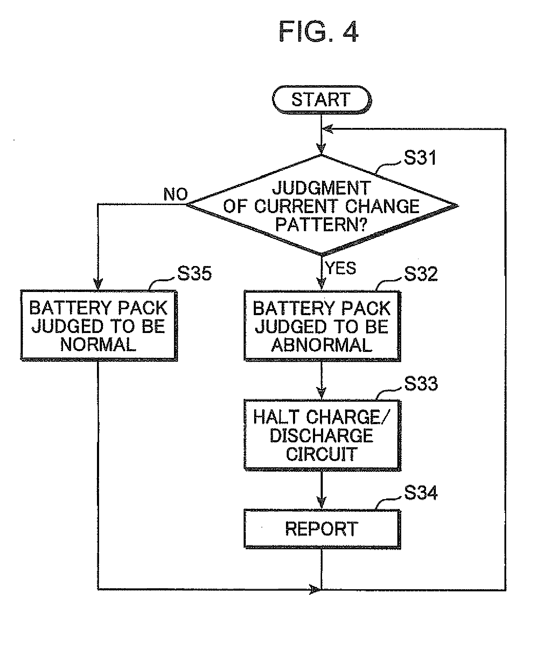

Fig. 4 is a flowchart showing an example of operation when the control portion 22 judges that a battery pack 10 is abnormal. First, the external judgment portion 221 judges whether the current detected by the current sensor 21 exhibits the current change pattern A (step S31).

And, when the external judgment portion 221 judges that the current detected by the current sensor 21 exhibits the current change pattern A (YES in step S31), it is judged that the battery portion 2 of at least one among the battery packs 10A and 10B is abnormal (step S32).

Next, the overall control portion 222 halts the charge/discharge circuit 23 (step S33). Next, the overall control portion 222 uses the report portion 24 to report to the user that a battery pack 10 is abnormal (step S34), and processing returns to step S31.

On the other hand, when in step S31 the current detected by the current sensor 21 does not exhibit the current change pattern A (NO in step S31), the external judgment portion 221 judges that both the battery packs 10A and 10B are normal (step S35), and processing returns to step S31.

As explained above, by means of a power supply device 100 of this embodiment, when a certain battery pack 10 detects an abnormality in its own battery portion 2, it causes its own switching element 5 to operate in an on/off sequence determined in advance, and thereafter turns off the switching element 5. By this means, the flow of current in the abnormal battery portion 2 can be prevented.

In another battery pack 10, on the other hand, the current detected by the current sensor 3 changes in a current change pattern A corresponding to this on/off sequence, and therefore an abnormality in the certain battery pack 10 can be detected on the basis of this current change pattern A. Then, upon detecting an abnormality in the certain battery pack 10, the other battery pack 10 turns off its own switching element 5.

Consequently even when a separate communication circuit to notify a battery pack 10 that the state of its own battery portion 2 is abnormal is not provided, the other battery pack 10 can be notified that the state of its battery portion 2 is abnormal.

Further, a battery pack 10 which has detected that its own battery portion 2 is in an abnormal state turns off its own switching element 5, and moreover a battery pack 10 which has judged that the other battery pack 10 is abnormal also switches off its own switching element 5.

By this means, the switching elements 5 of all series-connected battery packs 10 are turned off, so that battery packs 10 can be prevented from rising to high voltages sufficient to cause shocks, and tasks to replace battery packs 10 can be performed safely.

In the above explanation, an example was presented in which the connection terminals 6, 7 were used for both charging and discharging; but separately from connection terminals for charging, dedicated connection terminals for discharging may also be provided. In this case, a battery pack 10 may have a switching element 5 disposed between the charging connection terminal and the battery portion 2, and a switching element 5 disposed between the discharge connection terminal and the battery portion 2.

Further, in the above explanation, by detecting the temperature of the battery portion 2 a judgment was made as to whether the state of the battery portion 2 is abnormal; but other configurations are possible, and a judgment can be made as to whether the state of a battery portion 2 is abnormal by detecting the voltage across the positive electrode and negative electrode of each secondary battery 2x constituting the battery portion 2, or by detecting the voltage across the positive electrodes and negative electrodes of all secondary batteries 2x constituting the battery portion 2.

In this case, in the control portion 4, a voltage detection portion may be provided in place of the temperature detection portion 41. Further, the positive electrode and negative electrode of each of the secondary batteries 2x may be connected to the control portion 4 via a voltage detection line. And, an A/D converter may be provided on each voltage detection line, and the voltage detection portion may capture the voltages of each of the secondary batteries 2x periodically from each of the A/D converters.

Further, a judgment as to whether the state of the battery portion 2 is abnormal may be made by detecting the current flowing in the battery portion 2. In this case, in place of the temperature detection portion 41 in the control portion 4, a current detection portion is provided, and the current value detected by the current sensor 3 may be captured periodically by the current detection portion.

Further, in the above explanation a plurality of temperature sensors T were provided, but other configurations are possible, and a single sensor may be employed. In this case, the abnormality judgment portion 42 may judged that the state of the battery portion 2 is abnormal when a single temperature detection value is greater than a threshold value TH1.

Technical characteristics of the above power supply device can be summarized as follows.

(1) The above power supply device comprises a plurality of battery packs connected in series. Each battery pack includes a battery portion, including one or a plurality of secondary batteries; a connection terminal which receives current flowing in the battery portion; a switching clement which opens and closes a charge/discharge path between the battery portion and the connection terminal; a state detection portion which detects a state of the battery portion; an abnormality judgment portion which judges whether the state of the battery portion is abnormal, based on the state of the battery portion detected by the state detection portion; a charge/discharge control portion which, when the state of the battery portion is judged to be abnormal by the abnormality judgment portion, causes the switching element to operate in an on/off sequence set in advance, and then turns off the switching element; and a first current detection portion which detects a current flowing in the battery portion; and is **characterized in that**, when the current detected by the first current detection portion has changed in a current change pattern corresponding to the on/off sequence, the abnormality judgment portion judges that another battery pack is abnormal, and turns off the switching element.

By means of this configuration, when a certain battery pack detects an abnormality in its own battery portion, after causing its own switching element to operate in an on/off sequence set in advance, the switching element is turned off. By this means, flowing of current in the abnormal battery portion can be prevented.

On the other hand, in another battery pack, the current detected by the first current detection portion has changed in a current change pattern corresponding to this on/off sequence, and so based on this current change pattern, abnormality of a different battery pack can be detected. And this other battery pack, upon detecting abnormality of a different battery pack, turns off its own switching element.

Hence even when a communication circuit is not separately provided to notify a battery pack that the state of its own battery portion is abnormal, another battery pack can be notified that the state of its battery portion is abnormal.

Further, a battery pack which has detected that the state of its own battery portion is abnormal turns off its own switching element, and moreover a battery pack which has judged that another battery pack is abnormal also turns off its own switching element.

By this means, the switching elements of all the series-connected battery packs are turned off, so that battery packs can be prevented from rising to high voltages sufficient to cause shocks, and tasks to replace battery packs can be performed safely.

(2) It is preferable that the above power supply device further comprise a charge/discharge circuit which charges and discharges the battery packs; a second current detection portion which is provided outside the battery packs, and detects the current flowing in the charge/discharge path; an external judgment portion which, when the current detected by the second current detection portion has changed in a current change pattern corresponding to the on/off sequence, judges that one of the battery packs among the plurality of battery packs is abnormal,; and an overall control portion which, when a battery pack is judged to be abnormal by the external judgment portion, halts the charge/discharge circuit.

By means of this configuration, a second current detection portion is provided in the charge/discharge path outside the battery packs. And, when the current detected by this second current detection portion has changed in a current change pattern corresponding to an on/off sequence set in advance, the external judgment portion judges that one of the battery packs is abnormal. And, the overall control portion halts the charge/discharge circuit.

Hence even when a communication circuit to notify a battery pack that the state of its own battery portion is abnormal is not provided, the battery pack can notify the external judgment portion that the state of its battery portion is abnormal.

Further, the external judgment portion, upon judging that one of the battery packs is abnormal, halts the charge/discharge circuit, so that the supply of current to the abnormal battery pack is halted. By this means, power losses in the charge/discharge circuit can be reduced.

(3) In the above power supply device, it is preferable that a report portion be provided which, when the battery pack is judged to be abnormal by the external judgment portion, reports this fact.

By means of this configuration, when a battery pack abnormality occurs, this fact is reported, so that the user can promptly recognize that a battery pack is abnormal.

(4) In the above power supply device, it is preferable that the state detection portion detect, as the state of the battery portion, the temperature, voltage, or current of the battery portion.

By means of this configuration, the temperature, voltage or current of the battery portion is detected as the state of the battery portion, and abnormality of the battery portion is judged, so that whether an abnormality exists in the battery pack can be judged with good precision.

(5) In the above power supply device, it is preferable that in the on/off sequence, an operation in which the switching element is turned off for a constant interval and is then turned on for a constant interval be repeated.

By means of this configuration, after the switching element has been turned off for a constant interval, the switching element is turned on for a constant interval, so that the current change pattern is a square wave, and an abnormality in the battery pack can be detected with good precision.

(6) In the above power supply device, it is preferable that in the on/off sequence, a first off interval and a first on interval of the switching element be the same, and that a second on interval be longer than a second off interval.

By means of this configuration, the first off interval and first on interval of the switching element are the same, so that the duty ratio for the first period of the current change pattern is 50%, and because the second on interval of the switching element is longer than the second off interval, the duty ratio for the second period of the current change pattern is higher than 50%.

Consequently the current change pattern can be made a unique waveform, intermixing with noise and other signals can be avoided, and a battery pack abnormality can be detected with good precision using a small number of pulses.

(7) The battery pack according to another aspect of the invention comprises a battery portion, including one or a plurality of secondary batteries; a connection terminal which receives current flowing in the battery portion; a switching element which opens and closes a charge/discharge path between the battery portion and the connection terminal; a state detection portion which detects a state of the battery portion; an abnormality judgment portion which judges whether the state of the battery portion is abnormal, based on the state of the battery portion detected by the state detection portion; a charge/discharge control portion which, when the state of the battery portion is judged to be abnormal by the abnormality judgment portion, causes the switching element to operate in an on/off sequence set in advance, and then turns off the switching element; and a first current detection portion which detects a current flowing in the battery portion; and is **characterized in that**, when the current detected by the first current detection portion has changed in a current change pattern corresponding to the on/off sequence, the abnormality judgment portion judges that another battery pack connected in series is abnormal, and turns off the switching element.

By means of this configuration, when the state of the battery portion becomes abnormal, the switching element is operated in an on/off sequence set in advance. By this means, the current received from the connection terminal changes in a current change pattern corresponding to this on/off sequence. Hence by detecting this current change pattern, battery packs connected to this battery pack and similar can judged battery pack abnormality.

As a result, even when a separate communication circuit for notification of battery portion abnormality is not provided, other battery packs and the like can be notified of the battery pack abnormality.

### Industrial Applicability

A power supply device of this invention can be used suitably in portable personal computers, digital cameras, portable telephone sets and other electronic equipment, in electric automobiles, hybrid automobiles and other vehicles, in power supply systems combining secondary batteries with solar cells and electric generators, and in various other battery-equipped devices, systems and similar.

## Claims

1. A power supply device, comprising a plurality of battery packs connected in series, wherein each battery pack includes:
a battery portion, including one or a plurality of secondary batteries;
a connection terminal which receives current flowing in the battery portion;
a switching element which opens and closes a charge/discharge path between the battery portion and the connection terminal;
a state detection portion which detects a state of the battery portion;
an abnormality judgment portion which judges whether the state of the battery portion is abnormal, based on the state of the battery portion detected by the state detection portion;
a charge/discharge control portion which, when the state of the battery portion is judged to be abnormal by the abnormality judgment portion, causes the switching element to operate in an on/off sequence set in advance, and then turns off the switching element; and
a first current detection portion which detects a current flowing in the battery portion, and
wherein, when the current detected by the first current detection portion has changed in a current change pattern corresponding to the on/off sequence, the abnormality judgment portion judges that another battery pack is abnormal, and turns off the switching element.

2. The power supply device according to Claim 1, further comprising:
a charge/discharge circuit which charges and discharges the battery packs;
a second current detection portion which is provided outside the battery packs, and detects a current flowing in the charge/discharge path;
an external judgment portion which, when the current detected by the second current detection portion has changed in a current change pattern corresponding to the on/off sequence, judges that one of the battery packs among the plurality of battery packs is abnormal; and
an overall control portion which, when a battery pack is judged to be abnormal by the external judgment portion, halts the charge/discharge circuit.

3. The power supply device according to Claim 1 or Claim 2, further comprising a report portion which, when the battery pack is judged to be abnormal by the external judgment portion, reports this fact.

4. The power supply device according to any one of Claims 1 to 3, wherein the state detection portion detects, as the state of the battery portion, a temperature, voltage, or current of the battery portion.

5. The power supply device according to any one of Claims 1 to 4, wherein, in the on/off sequence, an operation in which the switching element is turned off for a constant interval and is then turned on for a constant interval is repeated.

6. The power supply device according to Claim 5, wherein, in the on/off sequence, a first off interval and a first on interval of the switching element are the same, and a second on interval is longer than a second off interval.

7. A battery pack, comprising:
a battery portion, including one or a plurality of secondary batteries;
a connection terminal which receives current flowing in the battery portion;
a switching element which opens and closes a charge/discharge path between the battery portion and the connection terminal;
a state detection portion which detects a state of the battery portion;
an abnormality judgment portion which judges whether the state of the battery portion is abnormal, based on the state of the battery portion detected by the state detection portion;
a charge/discharge control portion which, when the state of the battery portion is judged to be abnormal by the abnormality judgment portion, causes the switching element to operate in an on/off sequence set in advance, and then turns off the switching element; and
a first current detection portion which detects a current flowing in the battery portion, wherein, when the current detected by the first current detection portion has changed in a current change pattern corresponding to the on/off sequence, the abnormality judgment portion judges that another battery pack connected in series is abnormal, and turns off the switching element.
